# EUROPEAN PATENT APPLICATION

(11) **EP 4 722 490 A1**
(43) Date of publication of application: **08.04.2026**
(21) Application number: 25206403.5
(22) Date of filing: 02.10.2025
(51) Int. Cl.: E21B 43/00

(54) **SYSTEM AND METHOD FOR RESERVOIR PERFORMANCE DIAGNOSTICS THROUGH ARTIFICIAL INTELLIGENCE AGENTS**

(30) Priority: 07.10.2024 US 202463704510 P
(71) Applicant: Abu Dhabi National Oil Company, Abu Dhabi 00971 (AE)
(72) Inventor: SHAIK, Abdul Ravoof, 00971 Abu Dhabi (AE); KHAN, Muhammad Navaid, 00971 Abu Dhabi (AE); BINAMRO, Ahmed Abdulla Omar Ahmed, 00971 Abu Dhabi (AE); KLOUCHA, Chakib Kada, 00971 Abu Dhabi (AE)
(74) Representative: Bardehle Pagenberg Partnerschaft mbB Patentanwälte Rechtsanwälte

(57) **Abstract**

A system, a method, a computer program, and a computer-readable storage medium for reservoir performance diagnostics through intelligence (AI) agents. A method may include receiving production data from one or more wells belonging to one or more sectors of one or more reservoirs of a field; determining performance metrics associated with the one or more wells at a well-level, a sector-level, a reservoir-level, and/or a field-level; determining one or more performance anomalies associated with the one or more wells, the one or more sectors, the one or more reservoirs, and/or the field; and generating one or more solutions for improving the performance of the one or more wells, the one or more sectors, the one or more reservoirs, and/or the field.

## Description

### BACKGROUND

### Technical Field

The present disclosure relates generally to reservoir performance diagnostics, and more specifically to a system, a method, a computer program, and a computer-readable storage medium for reservoir performance diagnostics through artificial intelligence (Al) agents.

### Introduction

In oil/gas production operations, optimizing reservoir performance is a critical task to achieve a balance between maximizing oil/gas recovery, ensuring economic viability, maintaining environmental standards, and prolonging the productive life of the reservoir. Reservoir performance reviews involve in-depth technical analyses of various data types to assess hydrocarbon reservoir performance. These analyses are essential for identifying anomalies and opportunities for improvement. Examples of existing solutions and workflows can be found in the following articles:

Article *"*Automated Sector Performance Review - A Collaborative Process to Identify, Interpret and Implement Profitable Opportunities" (Muhammad Navaid Khan, et al.; paper presented at the Abu Dhabi International Petroleum Exhibition & Conference, Abu Dhabi, UAE, November 2019;doi: https://doi.org/10.2118/197500-MS), the content of which is expressly incorporated by reference herein in its entirety.

Article *"*Intelligent Annual Reservoir Performance Reporting System i-ARPR - A Fascinating Journey from a Concept to Reality" (Muhammad Navaid Khan, et al.; paper presented at the Abu Dhabi International Petroleum Exhibition & Conference, Abu Dhabi, UAE, November 2020. doi: https://doi.org/10.2118/203182-MS), the content of which is expressly incorporated by reference herein in its entirety.

Article *"*Building ADNOC's Pillars for Process Standardization and Best Practices through an Integrated Reservoir Management Framework" (Mohamed A. Al Marzouqi, et al.; paper presented at the Abu Dhabi International Petroleum Exhibition & Conference, Abu Dhabi, UAE, November 2016; doi: https://doi.orq/10.2118/183421-MS), the content of which is expressly incorporated by reference herein in its entirety.

Article *"*Improving Governance of Integrated Reservoir and Information Management Leveraging Business Process Management and Workflow Automation" (Frontender Alvaro Escorcia, et al.; paper presented at the SPE Annual Technical Conference and Exhibition, San Antonio, Texas, USA, October 2017; doi: https://doi.orq/10.2118/187375-MS), the content of which is expressly incorporated by reference herein in its entirety.

Article *"*Benefits of Implementing Integrated Reservoir Management IRM Framework by Closing Gaps in People, Process and Technology - Second Act' (Mohamed Al Marzouqi, et al.; paper presented at the Abu Dhabi International Petroleum Exhibition & Conference, Abu Dhabi, UAE, November 2017; doi: https://doi.orq/10.2118/188348-MS), the content of which is expressly incorporated by reference herein in its entirety.

Article *"*Upstream Data Architecture and Data Governance Framework for Efficient Integrated Upstream Workflows and Operations" (Richard Mohan David, et al.; paper presented at the Abu Dhabi International Petroleum Exhibition & Conference, Abu Dhabi, UAE, November 2017; doi: https://doi.orq/10.2118/188962-MS), the content of which is expressly incorporated by reference herein in its entirety.

Article *"*Faster and Profitable Production Optimization Decisions through Workflow Automation and Business Process Management - A Unique Concept" (Muhammad Navaid Khan, et al.; paper presented at the Abu Dhabi International Petroleum Exhibition & Conference, Abu Dhabi, UAE, November 2018; doi: https://doi.org/10.2118/193343-MS), the content of which is expressly incorporated by reference herein in its entirety.

The overall process of the existing solutions for reservoir performance evaluation is quite laborious, yet extremely important. Owing to the nature of the task, at its best frequency, these reviews take place once a year. However, more frequent reviews are necessary to monitor changes in reservoir dynamics. Consequently, current systems are inadequate for meeting ambitious production and reservoir development goals.

The present disclosure provides techniques for enhanced workflows aimed at achieving quicker performance updates, thereby providing decision-makers with the agility they need.

### SUMMARY

The various embodiments detailed herein relate to a system, a method, a computer program, and a computer-readable storage medium for reservoir performance diagnostics through artificial intelligence (AI) agents. Additionally, the embodiments and aspects of the present invention provide other benefits that will become clear to those skilled in the art from the foregoing description.

A method may include receiving a set of data related to one or more wells, the one or more wells belonging to one or more sectors of one or more reservoirs of a field; determining, based on the received set of data, performance metrics associated with the one or more wells at a well-level, a sector-level, a reservoir-level, and/or a field-level; determining, based on the determined performance metrics, one or more performance characteristics associated with the one or more wells, the one or more sectors, the one or more reservoirs, and/or the field; and generating, based on evaluation of the one or more performance characteristics, one or more solutions for improving performance of the one or more wells, the one or more sectors, the one or more reservoirs, and/or the field. In some aspects, the set of data may include production data, injection data, measurement data (e.g., pressure, fluid PVT (pressure, volume and temperature, etc.) and/or other type of data. In some aspects, a possible solution may be a mitigation action associated with a performance anomaly identified based on evaluation of the one or more performance characteristics. In some aspects, a possible solution may be a performance enhancement action associated with a performance enhancement opportunity identified based on evaluation of the one or more performance characteristics.

A system may include a processor; memory accessible to the processor; processor-executable instructions stored in the memory executable to instruct the system to: receive a set of data related to one or more wells, the one or more wells belonging to one or more sectors of one or more reservoirs of a field; determine, based on the received set of data, performance metrics associated with the one or more wells at a well-level, a sector-level, a reservoir-level, and/or a field-level; determine, based on the determined performance metrics, one or more performance characteristics associated with the one or more wells, the one or more sectors, the one or more reservoirs, and/or the field; and generate, based on evaluation of the one or more performance characteristics, one or more solutions for improving performance of the one or more wells, the one or more sectors, the one or more reservoirs, and/or the field. In some aspects, the set of data may include production data, injection data, measurement data (e.g., pressure, fluid PVT (pressure, volume and temperature, etc.) and/or other type of data. In some aspects, a possible solution may be a mitigation action associated with a performance anomaly identified based on evaluation of the one or more performance characteristics. In some aspects, a possible solution may be a performance enhancement action associated with a performance enhancement opportunity identified based on evaluation of the one or more performance characteristics.

One or more computer-readable storage media may include processor-executable instructions to instruct a computing system to: receive a set of data related to one or more wells, the one or more wells belonging to one or more sectors of one or more reservoirs of a field; determine, based on the received set of data, performance metrics associated with the one or more wells at a well-level, a sector-level, a reservoir-level, and/or a field-level; determine, based on the determined performance metrics, one or more performance characteristics associated with the one or more wells, the one or more sectors, the one or more reservoirs, and/or the field; and generate, based on evaluation of the one or more performance characteristics, one or more solutions for improving performance of the one or more wells, the one or more sectors, the one or more reservoirs, and/or the field. In some aspects, the set of data may include production data, injection data, measurement data (e.g., pressure, fluid PVT (pressure, volume and temperature, etc.) and/or other type of data. In some aspects, a possible solution may be a mitigation action associated with a performance anomaly identified based on evaluation of the one or more performance characteristics. In some aspects, a possible solution may be a performance enhancement action associated with a performance enhancement opportunity identified based on evaluation of the one or more performance characteristics.

The disclosed system and method may incorporate various components, circuits, processes, algorithms, etc. (collectively referred to as "elements"). These elements can be implemented using electronic hardware, computer software, or a combination of both, depending on the specific application and design constraints of the overall system.

For instance, an element, any portion of an element, or any combination of elements can be implemented as a "processing system" that includes one or more processors. These processors may include microprocessors, microcontrollers, graphics processing units (GPUs), central processing units (CPUs), application processors, digital signal processors (DSPs), reduced instruction set computing (RISC) processors, systems on a chip (SoC), baseband processors, field programmable gate arrays (FPGAs), programmable logic devices (PLDs), state machines, gated logic, discrete hardware circuits, and other suitable hardware designed to perform the various functions described in this disclosure. The processors within the processing system may execute software, broadly defined to include instructions, code, programs, software components, applications, routines, subroutines, executables, procedures, functions, etc., whether referred to as software, firmware, middleware, microcode, hardware description language, or otherwise.

Therefore, in one or more examples, the described functions can be implemented in hardware, software, or any combination thereof. If implemented in software, these functions may be stored or encoded as instructions or code on a computer-readable medium. Computer-readable media include any available media that can be accessed by a computer, such as random-access memory (RAM), read-only memory (ROM), electrically erasable programmable ROM (EEPROM), optical disk storage, magnetic disk storage, other magnetic storage devices, combinations of these types of media, or any other medium capable of storing executable code in the form of instructions or data structures accessible by a computer.

### BRIEF DESCRIPTION OF THE DRAWINGS

The accompanying drawings are included to provide a further understanding of the invention. The drawings illustrate embodiments of the invention and, together with the description, serve to explain the principles of the invention.

In the drawings:
Fig. 1 illustrates an example of a system in accordance with aspects of the present disclosure.
Fig. 2 is a flowchart of an example of a method in accordance with aspects of the present disclosure.

### DETAILED DESCRIPTION

The petroleum industry typically employs the following hierarchical structure to organize and manage the extraction process:
**Field:** This is the largest unit, spanning a significant area of land or seabed. A field can encompass multiple reservoirs, each with distinct geological characteristics and hydrocarbon content.
**Reservoir:** Within a field, there are individual reservoirs, which are specific geological formations that contain trapped hydrocarbons. Reservoirs are separated by impermeable rock layers.
**Sector:** Reservoirs are often divided into sectors for operational purposes. This segmentation facilitates more efficient management and development of the reservoir.
**Well:** At the finest level of granularity, each sector may contain multiple wells drilled to extract oil/gas from the reservoir. These wells are critical for the actual extraction process.

According to techniques disclosed herein, an example solution for reservoir performance reviews and optimizations may be outlined through the following six steps:

### Step-1: Sector Identification and Data Collection

The process commences with the division of the reservoir into logically connected flow units or sectors, both horizontally and vertically. Advanced digital workflows gather well performance data from various repositories for each sector, encompassing production, injection, pressure, and other reservoir surveillance metrics. This data undergoes validation and analysis by a Subject Matter Expert (SME) using diagnostic plots, maps, key performance indicators (KPIs), and/or tabulated information to ensure its accuracy and reliability.

### Step-2: Data Validation

The SME validates the collected data to confirm its accuracy and reliability. This step is crucial as it ensures that only high-quality data is used in further analyses, forming a solid foundation for the subsequent integration workflow.

### Step-3: Data Analysis and Insight Generation

A data integrator (typically a senior engineer) analyzes the data trends and generates insights into the reservoir's performance. The analysis involves interpreting the data using the integrator's expertise and experience, which adds a layer of subjectivity but also depth to the understanding of reservoir dynamics.

### Step-4: Performance Status Compilation

The insights obtained at Step-3 are reviewed alongside KPIs and tabulated data to compile a comprehensive performance status for each reservoir sector. All sectors undergo this process from Step-1 to Step-4 to identify which areas need further attention and detailed analysis, ensuring a holistic understanding of the reservoir.

### Step-5: Detailed Performance Evaluation

Prioritized sectors identified in the previous step undergo a detailed evaluation process to determine performance characteristics. This involves a thorough examination to identify any performance anomalies or performance enhancement opportunities.

### Step-6: Corrective Action and Feasibility Assessment

Finally, corrective actions or enhancement actions are identified based on the detailed analysis. The feasibility of executing these actions is assessed, and the results are incorporated into a technical-economic proposal for approval. This ensures that any recommended interventions are both technically viable and economically beneficial.

According to the techniques disclosed herein, the above described process may be more efficiently performed with the help of Al based solutions. In detail, business analytics platforms generate cross plots and trends (also known as diagnostic plots) for various reservoir performance parameters. These plots and trends are interpreted by Al based solutions such as supervised learning algorithms, reinforcement learning algorithms and generative Al algorithms to provide insights without a need for manual interpretation. Subsequently, based on predefined combinations and analytically identified relationships of performance indices, the system identifies the underlying causes of reservoir performance deterioration and recommends potential mitigation plans. Alternatively, the system identifies performance enhancement opportunities and recommend potential enhancement actions. This enhances decision quality and enables efficient execution.

The incorporation of Al algorithms into reservoir performance evaluation enables near real-time analysis. These algorithms can continuously process data at defined intervals, providing rapid summaries of reservoir status, highlighting anomalies and opportunities, and suggesting potential root causes of performance issues. This solution may empower technical teams to proactively manage reservoir performance, thereby preventing severe and costly problems.

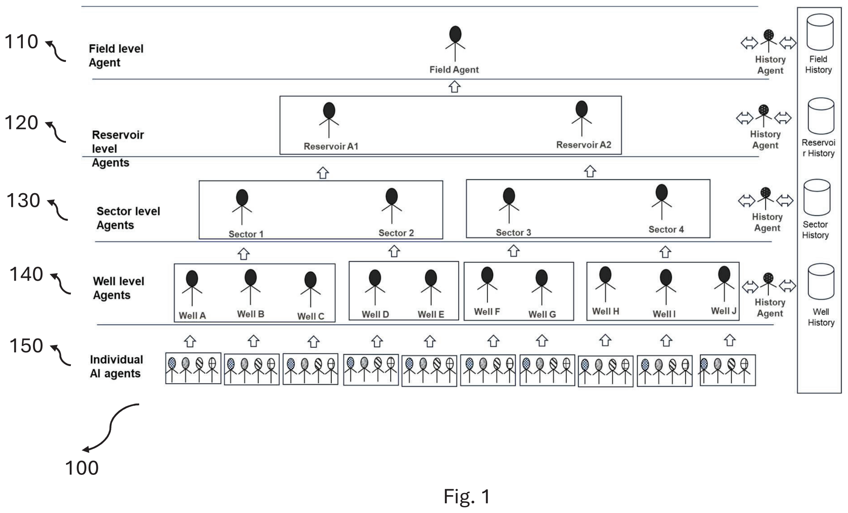

Fig. 1 illustrates a system 100 in accordance with aspects of the present disclosure. As shown in Fig. 1, the system 100 includes multiple Al agents divided into different levels: field level 110, reservoir level 120, sector level 130, well level 140, and individual level 150. Each level includes one or more Al agents.

At the individual level 150, for each well, one or more individual Al agents may be configured for specific performance metrics such as water cut,
gas oil ratio (GOR), pressure, production sustainability, injection effectiveness, sweep efficiency, overall well performance, overall sector performance, overall reservoir performance, and/or overall field performance.

For example, an individual Al agent may be a water cut analysis agent configured to analyze water-to-oil ratio for the produced fluids. By utilizing supervised learning algorithms, reinforcement learning algorithms and/or generative Al algorithms, the water cut analysis agent may be further configured to identify trends and suggest optimization strategies based on approved field development plan.

In another example, an individual Al agent may be a GOR analysis agent configured to monitor gas-oil ratio. The GOR analysis agent may be further configured to provide insights into the reservoir's health and recommend adjustments to maintain or improve the well production rates.

In a further example, an individual Al agent may be a pressure analysis agent configured to track reservoir pressure changes, Moreover, the pressure analysis agent may be configured to suggest a mitigation plan if the pressure deviates from an approved field development plan.

In a further example, an individual Al agent may be an injection effectiveness agent for injection wells. The injection effectiveness agent may be configured to evaluate the effectiveness of water or gas injection in maintaining reservoir pressure and enhancing oil recovery.

In a further example, an individual Al agent may be a sweep efficiency analysis agent configured to assess an efficiency of hydrocarbon recovery from the reservoir. The sweep efficiency analysis agent may be further configured to suggest improvements in well placement and injection strategies.

In a further aspect, an individual Al agent may be configured to generate one or more diagnostic plots and/or maps for monitoring, diagnosing, and/or optimizing the performance of the one or more wells at a well-level, a sector-level, a reservoir-level, and/or a field-level. Examples of such diagnostic plots are listed in Table I, which contains a non-exhaustive list of possible diagnostic plots.

**Table I**

| **ID** | **Diagnostic Plots** | **Variables (Y/X)** |
|---|---|---|
| 1 | ABC plot | Y axis is current to previous oil production rate. |
| | | X axis is current to previous water production rate |
| 2 | Gas Rate vs Time, per Well | Y Axis: Gas rate production |
| | | X Axis: Time |
| 3 | GOR vs Time, per Well | Y Axis: Gas Oil Ratio (GOR) |
| | | X Axis: time |
| 4 | Hall plot (Cum WHPI x Days vs Cum Injection) | Y axis is Injection Wellhead Pressure x number of days injection |
| | | X axis is Cumulative volume injection |
| 5 | Integral Hall plot | Y Axis: Cumulative volume of water injected at time t |
| | | X Axis: time |
| 6 | Modified Hall plot | As Hall plot, additionally Injection rates also plotted on Y axis |
| 7 | Oil rate vs cumulative production (Semilog) per Well | Y Axis: Oil rate |
| | | X Axis: Cumulative production |
| 8 | Oil rate vs time, per Well | Y Axis: Oil rate (Qo) |
| | | X Axis: Time |
| 9 | Oil rate vs time (Decline analysis plot), per Well | Y Axis: well oil production rate |
| | | X Axis: time |
| 10 | Reciprocal PI vs Material Balance Time, per Well | Y Axis: Reciprocal of Injector Productivity Index |
| | | X Axis: Time |
| 11 | WCT vs time | Y Axis: Water cut (WCT) |
| | | X Axis: time |
| 12 | WOR vs Cumulative oil (Semilog) | Y Axis: Water Oil ratio (WOR) plotted on log scale |
| | | X Axis: Cumulative Oil produced |
| 13 | WOR vs time (Log-Log) | Y Axis: Water Oil ratio (WOR) |
| | | X Axis: Time |
| 14 | Conformance Plot per injector | Oil Cumulative vs. Water injected |
| 15 | Conformance Plot per producer | Oil Cumulative vs. Water injected |
| 16 | Cumulative water injection and water cut vs time | Y Axis: Cumulative water injection and water cut |
| | | X Axis: Time. |
| 17 | Flowing Pressure vs depth | Y Axis: Depth |
| | | X Axis: Flowing pressure |
| 18 | Flowing pressure vs inflow liquid rate | Y Axis: Flowing pressure |
| | | X Axis: Inflow liquid rate |
| 19 | Flowing pressure vs outflow liquid rate | Y Axis: Flowing pressure |
| | | X Axis: Outflow liquid rate |
| 20 | Flowing pressure vs time | Y Axis: Flowing pressure |
| | | X Axis: Time |
| 21 | Fluid production vs depth at a given time | Y Axis: Depth |
| | | X Axis: Fluid production |
| 22 | Oil, Water or Gas rate (Last well test and dates) map | Validated (or Raw) test rate & dates vs. well location |
| 23 | Oil rate vs Water Injection rate (Scatter Injection Efficiency) | Oil rate vs Water Injection rate |
| 24 | Pressure survey vs depth at a given time | Y Axis: Depth |
| | | X Axis: Pressure |
| 25 | Top High/Low Cumulative Oil per well | Y Axis: Water cut |
| | | X Axis: Well number |
| 26 | Top High/Low WCT per well | Y Axis: Water cut |
| | | X Axis: Well number |
| 27 | Water injection rate vs time | Y Axis: Water injection rate |
| | | X Axis: Time |
| 28 | WCT or WOR (Last well test) map | X Axis: X location. |
| | | Y Axis: Y location. |
| | | Z Axis: WCUT (WOR) |

For example, a Jordon plot and/or a Hall plot may be used for monitoring, diagnosing, and/or optimizing the performance of injection wells in waterflooding operations.

In another example, an Accumulated Barrels Cumulative (ABC) plot may be used to analyze and monitor the cumulative production or injection performance of wells over time.

In another example, a Chan analysis plot may be used for diagnosing and optimizing the performance of oil producing wells.

In a further aspect, one or more of the individual Al agents may be configured to determine Hydrocarbon Volume Injected (HCVI) versus Recovery Factor (RF) to evaluate and optimize the efficiency of hydrocarbon injection processes to maximize the recovery factor and enhance overall oil recovery from the reservoir.

In a further aspect, one or more of the individual Al agents may be configured to perform pressure mapping to visualize and analyze pressure distribution.

In a further aspect, one or more of the individual Al agents may be configured for history data mining to extract and analyze historical data from wells. Historical data may include Reservoir Performance Report (RPR), drilling and well intervention reports, Technology Performance Reports and/or well files.

In a further aspect, one or more of the individual Al agents may be configured to implement trend analysis to predict future movements or behaviors by analyzing historical data.

At the well level 140, each well may be equipped with a well-level Al agent configured to supervise the corresponding individual Al agents. For example, a well-level Al agent may be a supervisory agent configured to consolidate all the findings from the individual Al agents in a structure format, which can be used for a formal report, for a visualization interface, and/or to provide overall insight of the well behavior. Furthermore, the supervisory agent may be configured to provide notifications e.g., according to a pre-defined schedule.

At the sector level 130, each sector may be equipped with a sector-level Al agent configured to aggregate insights from the corresponding well-level Al agents for providing a consolidated view of the sector's performance. For example, a sector-level Al agent may also be a supervisory agent configured to consolidate all the findings from the well-level Al agents in a structure format, which can be used for a formal report, for a visualization interface, and/or to provide overall insight of the sector performance. Furthermore, the supervisory agent may be configured to provide notifications e.g., according to a pre-defined schedule or trigger levels.

At the reservoir level 120, each reservoir may be equipped with a reservoir-level Al agent configured to synthesize information from the corresponding sector-level Al agents to offer a holistic analysis of the reservoir's behavior. For example, a reservoir-level Al agent may also be a supervisory agent configured to consolidate all the findings from the sector-level Al agents in a structure format, which can be used for a formal report and as well as for a visualization interface. Furthermore, the supervisory agent may be configured to provide notifications e.g., according to a pre-defined schedule or trigger levels.

At the field level 110, the field may be equipped with a field-level Al agent configured to consolidate information from all the reservoirs in the field. For example, the field-level Al agent may also be a supervisory agent configured to consolidate all the findings from the reservoir-level Al agents in a structure format, which can be used for a formal report and as well as for a visualization interface. Furthermore, the supervisory agent may be configured to provide notifications e.g., according to a pre-defined schedule or trigger levels.

In a further aspect, the system 100 may include one or more mitigation agents. The one or more mitigation agents may be in a well-level, a sector-level, a reservoir-level, and/or a field-level. Alternatively, the one or more mitigation agents may not belong to a specific level. The one or more mitigation agents may be configured to analyze historic performance of mitigation actions to cure one more identified performance anomalies associated with the wells, sectors, reservoirs and/or the field. Moreover, the one or more mitigation agents may be configured to retain labelled information in a systematic data structure.

In a further aspect, the agents at their respective levels are configured to forward performance anomalies to the one or more mitigation agents. The one or more mitigation agents may then be configured to prescribe a potential solution with a certain degree of confidence based on the historic performance of mitigation actions in similar situations.

In a further aspect, the system 100 may include one or more enhancement opportunities agents. The one or more enhancement opportunities agents may be in a well-level, a sector-level, a reservoir-level, and/or a field-level. Alternatively, the one or more enhancement opportunities agents may not belong to a specific level. The one or more enhancement opportunities agents may be configured to retrieve information related to opportunities from e.g. an opportunity register. The information related to opportunities may be at a well-level, a sector-level, a reservoir-level, and/or a field-level.

In a further aspect, the one or more mitigation agents may be configured to collate information from one or more history agents and one or more enhancement opportunities agents. The one or more history agents and/or the one or more enhancement opportunities agents may utilize success rate of similar past mitigation actions to propose a confidence interval of the recommended actions.

In further aspects, the system 100 may be built on a modular architecture, allowing for scalability and adaptability. Each individual Al agent may be configured to operate autonomously yet communicate seamlessly with the corresponding well-level Al agent. The well-level Al agents may be configured, in turn, to interface with the sector-level Al agents and reservoir-level Al agents to ensure a cohesive performance management system.

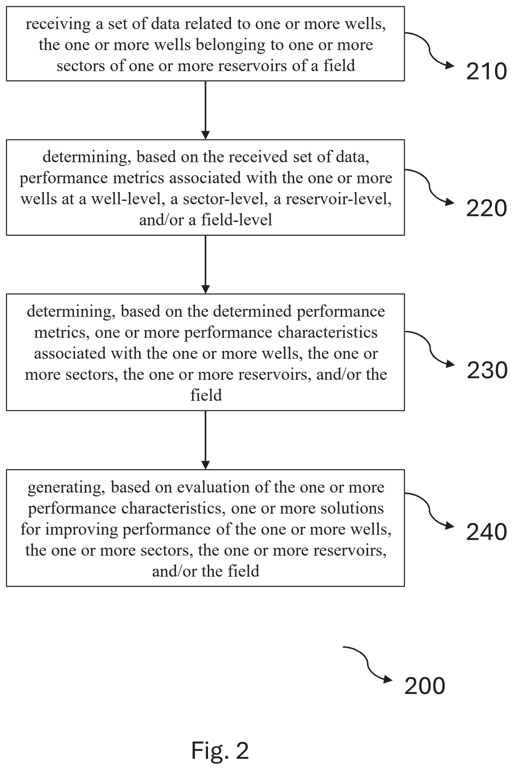

Fig. 2 is a flowchart of an example of a method 200 in accordance with aspects of the present disclosure. The method 200 may be performed by the system 100 of Fig. 1.

At 210, the system 100 may receive a set of data related to one or more wells, the one or more wells belonging to one or more sectors of one or more reservoirs of a field. In some aspects, the set of data may include production data, injection data, measurement data (e.g., pressure, fluid PVT (pressure, volume and temperature, etc.) and/or other type of data. For example, operations at block 210 may be performed by one or more agents at the individual level 150 of the system 100.

At 220, the system 100 may determine, based on the received set of data, performance metrics associated with the one or more wells at a well-level, a sector-level, a reservoir-level, and/or a field-level. For example, operations at block 220 may be performed by the individual agents 150 and/or one or more agents at the well-level 140, the sector-level 130, the reservoir-level 120, and/or the field-level 110 of the system 100.

At 230, the system 100 may determine, based on the determined performance metrics, one or more performance characteristics associated with the one or more wells, the one or more sectors, the one or more reservoirs, and/or the field. For example, operations at block 230 may be performed by one or more agents at the well-level 140, the sector-level 130, the reservoir-level 120, and/or the field-level 110 of the system 100.

At 240, the system 100 may generate, based on evaluation of the one or more performance characteristics, one or more solutions for improving performance of the one or more wells, the one or more sectors, the one or more reservoirs, and/or the field. For example, operations at block 240 may be performed by the one or more mitigation agents and/or the one or more enhancement opportunities agents of the system 100. The one or more mitigation agents and the one or more enhancement opportunities agents may be at a well-level, a sector-level, a reservoir-level, and/or a field-level. Alternatively, the one or more mitigation agents and the one or more enhancement opportunities agents may not belong to a specific level.

The specific order or hierarchy of blocks in the disclosed processes and flowcharts is illustrative of example approaches. Depending on design preferences, the order or hierarchy of these blocks may be rearranged. Additionally, some blocks may be combined or omitted. The accompanying method claims present elements of the various blocks in a sample order and are not meant to be limited to the specific order or hierarchy shown.

This description is provided to enable any person skilled in the art to practice the various aspects described herein. Various modifications to these aspects will be readily apparent to those skilled in the art, and the generic principles defined herein may be applied to other aspects. Thus, the claims are not intended to be limited to the aspects shown but are to be accorded the full scope consistent with the claim language. Unless otherwise stated, the term "some" refers to one or more. Combinations such as "at least one of A, B, or C," "one or more of A, B, or C," "at least one of A, B, and C," "one or more of A, B, and C," and "A, B, C, or any combination thereof" include any combination of A, B, and/or C, and may include multiples of A, multiples of B, or multiples of C. Specifically, these combinations may be A only, B only, C only, A and B, A and C, B and C, or A, B, and C, where any such combinations may contain one or more of A, B, or C. All structural and functional equivalents to the elements of the various aspects described throughout this disclosure that are known or later come to be known to those of ordinary skill in the art are expressly incorporated by reference and are intended to be encompassed by the claims.

The following aspects are illustrative only and may be combined with other aspects or teachings described herein, without limitation.

Aspect 1 is a method comprising: receiving a set of data related to one or more wells, the one or more wells belonging to one or more sectors of one or more reservoirs of a field; determining, based on the received set of data, performance metrics associated with the one or more wells at a well-level, a sector-level, a reservoir-level, and/or a field-level; determining, based on the determined performance metrics, one or more performance characteristics associated with the one or more wells, the one or more sectors, the one or more reservoirs, and/or the field; and generating, based on evaluation of the one or more performance characteristics, one or more solutions for improving performance of the one or more wells, the one or more sectors, the one or more reservoirs, and/or the field.

Aspect 2 is the method of aspect 1, wherein the set of data comprises production data, injection data, measurement data (e.g., pressure, fluid PVT (pressure, volume and temperature, etc.) and/or other type of data.

Aspect 3 is the method of any of aspects 1 and 2, wherein the one or more solutions comprise at least one of a mitigation action associated with a performance anomaly identified based on the evaluation of the one or more performance characteristics and a performance enhancement action associated with a performance enhancement opportunity identified based on the evaluation of the one or more performance characteristics.

Aspect 4 is the method of any of aspects 1 to 3, the method further comprising interpreting the set of data through supervised Al algorithms, prompt engineering and/or utilizing a large language model (LLM).

Aspect 5 is the method of any of aspects 1 to 4, the method further comprising data mining to extract and analyze historical data from wells, wherein generating the one or more solutions for improving performance of the one or more wells, the one or more sectors, the one or more reservoirs, and/or the field is based on results from the data mining.

Aspect 6 is the method of aspect 5, wherein generating the one or more solutions comprises generating the one or more solutions with a confidence interval.

Aspect 7 is the method of any of aspects 1 to 6, wherein the performance metrics include one or more of the following: water cut, gas oil ratio (GOR), pressure, production sustainability, injection effectiveness, sweep efficiency, overall well performance, overall sector performance, overall reservoir performance, and/or overall field performance.

Aspect 8 is the method of any of aspects 1 to 7, the method further comprising generating one or more diagnostic plots and/or maps for monitoring, diagnosing, and/or optimizing the performance of the one or more wells, the one or more sectors, the one or more reservoirs, and/or the field.

Aspect 9 is a system comprising a processor; memory accessible to the processor; processor-executable instructions stored in the memory executable to instruct the system to: receive a set of data related to one or more wells, the one or more wells belonging to one or more sectors of one or more reservoirs of a field; determine, based on the received set of data, performance metrics associated with the one or more wells at a well-level, a sector-level, a reservoir-level, and/or a field-level; determine, based on the determined performance metrics, one or more performance characteristics associated with the one or more wells, the one or more sectors, the one or more reservoirs, and/or the field; and generate, based on evaluation of the one or more performance characteristics, one or more solutions for improving the performance of the one or more wells, the one or more sectors, the one or more reservoirs, and/or the field.

Aspect 10 is the system of aspect 9, the system further comprising multi-level artificial intelligence (AI) agents.

Aspect 11 is the system of any of aspects 9 and 10, wherein the set of data comprises production data, injection data, measurement data (e.g., pressure, fluid PVT (pressure, volume and temperature, etc.) and/or other type of data.

Aspect 12 is the system of any of aspects 9 to 11, wherein the one or more solutions comprise at least one of a mitigation action associated with a performance anomaly identified based on the evaluation of the one or more performance characteristics and a performance enhancement action associated with a performance enhancement opportunity identified based on the evaluation of the one or more performance characteristics.

Aspect 13 is the system of any of aspects 9 to 12, wherein the processor-executable instructions stored in the memory are further executable to instruct the system to interpret the set of data through supervised Al algorithms, prompt engineering and/or utilizing a large language model (LLM).

Aspect 14 is the system of any of aspects 9 to 13, wherein the processor-executable instructions stored in the memory are further executable to instruct the system to perform data mining to extract and analyze historical data from wells, wherein generating the one or more solutions for improving performance of the one or more wells, the one or more sectors, the one or more reservoirs, and/or the field is based on results from the data mining.

Aspect 15 is the system of aspect 14, wherein generating the one or more solutions comprises generating the one or more solutions with a confidence interval.

Aspect 16 is the system of any of aspects 9 to 15, wherein the performance metrics include one or more of the following: water cut, gas oil ratio (GOR), pressure, production sustainability, injection effectiveness, sweep efficiency, overall well performance, overall sector performance, overall reservoir performance, and/or overall field performance.

Aspect 17 is the system of any of aspects 9 to 16, wherein the processor-executable instructions stored in the memory are further executable to instruct the system to generate one or more diagnostic plots and/or maps for monitoring, diagnosing, and/or to optimize the performance of the one or more wells, the one or more sectors, the one or more reservoirs, and/or the field.

Aspect 18 is one or more non-transitory computer-readable storage media comprising processor-executable instructions to instruct a computing system to: receive a set of data related to one or more wells, the one or more wells belonging to one or more sectors of one or more reservoirs of a field; determine, based on the received set of data, performance metrics associated with the one or more wells at a well-level, a sector-level, a reservoir-level, and/or a field-level; determine, based on the determined performance metrics, one or more performance characteristics associated with the one or more wells, the one or more sectors, the one or more reservoirs, and/or the field; and generate, based on evaluation of the one or more performance characteristics, one or more solutions for improving performance of the one or more wells, the one or more sectors, the one or more reservoirs, and/or the field.
Aspect 19 is a computer program comprising instructions which, when the program is executed by a computer, cause the computer to carry out the method of any of aspects 1 to 8.

## Claims

1. A method comprising:
receiving (210) a set of data related to one or more wells, the one or more wells belonging to one or more sectors of one or more reservoirs of a field;
determining (220), based on the received set of data, performance metrics associated with the one or more wells at a well-level, a sector-level, a reservoir-level, and/or a field-level;
determining (230), based on the determined performance metrics, one or more performance characteristics associated with the one or more wells, the one or more sectors, the one or more reservoirs, and/or the field; and
generating (240), based on evaluation of the one or more performance characteristics, one or more solutions for improving performance of the one or more wells, the one or more sectors, the one or more reservoirs, and/or the field.

2. The method of claim 1, wherein the set of data comprises production data, injection data, and/or measurement data.

3. The method of any preceding claim, wherein the one or more solutions comprise at least one of a mitigation action associated with a performance anomaly identified based on the evaluation of the one or more performance characteristics and a performance enhancement action associated with a performance enhancement opportunity identified based on the evaluation of the one or more performance characteristics.

4. The method of any preceding claim, further comprising:
interpreting the set of data through supervised Al algorithms, prompt engineering and/or utilizing a large language model, LLM.

5. The method of any preceding claim, further comprising:
data mining to extract and analyze historical data from wells, wherein generating the one or more solutions for improving performance of the one or more wells, the one or more sectors, the one or more reservoirs, and/or the field is based on results from the data mining; and preferably wherein generating the one or more solutions comprises generating the one or more solutions with a confidence interval.

6. The method of any preceding claim, wherein the performance metrics include one or more of the following:
water cut,
gas oil ratio, GOR,
pressure,
production sustainability,
injection effectiveness,
sweep efficiency,
overall well performance,
overall sector performance,
overall reservoir performance, and
overall field performance.

7. The method of any preceding claim, further comprising:
generating one or more diagnostic plots and/or maps for monitoring, diagnosing, and/or optimizing the performance of the one or more wells, the one or more sectors, the one or more reservoirs, and/or the field.

8. A system comprising:
a processor;
memory accessible to the processor;
processor-executable instructions stored in the memory executable to instruct the system to:
receive a set of data related to one or more wells, the one or more wells belonging to one or more sectors of one or more reservoirs of a field;
determine, based on the received set of data, performance metrics associated with the one or more wells at a well-level, a sector-level, a reservoir-level, and/or a field-level;
determine, based on the determined performance metrics, one or more performance characteristics associated with the one or more wells, the one or more sectors, the one or more reservoirs, and/or the field; and
generate, based on evaluation of the one or more performance characteristics, one or more solutions for improving the performance of the one or more wells, the one or more sectors, the one or more reservoirs, and/or the field.

9. The system of claim 8, further comprising multi-level artificial intelligence, AI, agents.

10. The system of claim 8 or 9, wherein the set of data comprises production data, injection data, and/or measurement data; and/or
wherein the one or more solutions comprise at least one of a mitigation action associated with a performance anomaly identified based on the evaluation of the one or more performance characteristics and a performance enhancement action associated with a performance enhancement opportunity identified based on the evaluation of the one or more performance characteristics.

11. The system of any of claims 8 to 10, wherein the processor-executable instructions stored in the memory are further executable to instruct the system to:
interpret the set of data through supervised Al algorithms, prompt engineering and/or utilizing a large language model, LLM.

12. The system of any of claims 8 to 11, wherein the processor-executable instructions stored in the memory are further executable to instruct the system to:
perform data mining to extract and analyze historical data from wells, wherein generating the one or more solutions for improving the performance of the one or more wells and/or one or more sector and/or one or more reservoir of a field is based on results from the data mining;
and preferably wherein generating the one or more solutions comprises generating the one or more solutions with a confidence interval.

13. The system of any of claims 8 to 12, wherein the performance metrics include one or more of the following:
water cut,
gas oil ratio, GOR,
pressure,
production sustainability,
injection effectiveness,
sweep efficiency,
overall well performance,
overall sector performance,
overall reservoir performance, and
overall field performance.

14. The system of any of claims 8 to 13, wherein the processor-executable instructions stored in the memory are further executable to instruct the system to:
generate one or more diagnostic plots and/or one or more maps for monitoring, diagnosing, and/or optimize the performance of the one or more wells at a well-level, a sector-level, a reservoir-level, and/or a field-level.

15. A computer program comprising instructions which, when the program is executed by a computer, cause the computer to carry out the method of any of claims 1 to 7.
